# EUROPEAN PATENT APPLICATION

(11) **EP 4 766 047 A1**
(43) Date of publication of application: **24.06.2026**
(21) Application number: 24307174.3
(22) Date of filing: 18.12.2024
(51) Int. Cl.: H05K 7/20

(54) **LIQUID COOLING DEVICE**

(71) Applicant: OVH, 59100 Roubaix (FR)
(72) Inventor: CHEHADE, Ali, 59283 Moncheaux (FR); KLABA, Henryk, 59100 Roubaix (FR); HNAYNO, Mohamad, 59110 La Madeleine (FR)
(74) Representative: BCF Global

(57) **Abstract**

A liquid cooling device for mounting onto a heat-generating electronic component submerged in an immersion cooling liquid, is presented. The cooling device body having a first surface disposed on a bottommost side for mounting onto an upper surface of the electronic component in which the first surface is configured with a open recess formed along an outer periphery of the first surface, a thermal interface material (TIM) interposed between the first surface and the upper surface of the electronic component, and a resiliently deformable gasket mounted on, and seated within, the open recess along the outer periphery of the first surface. The gasket configured to deformably expand horizontally or vertically to establish a protective fluid-proof seal for the first surface of the cooling device body, the upper surface of the electronic component, and the TIM from the immersion cooling liquid.

## Description

### CROSS-REFERENCE TO RELATED APPLICATIONS

None.

### TECHNICAL FIELD

The present technology relates to liquid cooling devices for cooling heat-generating electronic components in computing infrastructures, such as, water blocks.

### BACKGROUND

Electronic equipment, for example servers, memory banks, computer discs, and the like, is conventionally grouped in equipment racks. Large data centers and other large computing infrastructures may contain thousands of racks supporting thousands or even tens of thousands of servers and other electronic equipment.

The electronic equipment mounted in the racks consumes large amounts of electric power and generates significant amounts of heat. Cooling needs are important in such racks. Some electronic equipment, such as processors, generate so much heat that they could fail within seconds in case of a lack of cooling. Moreover, with advancing technological progress, electronic equipment for computing purposes is not only becoming more performant but also has a greater associated thermal design power (TDP) (*i.e.,* a maximum amount of heat generated thereby which a cooling system should dissipate) thus emphasizing the need to improve cooling solutions.

Forced air-cooling has been traditionally used to disperse heat generated by such electronic equipment mounted in the racks. Air-cooling requires the use of powerful fans, and the provision of space between the electronic equipment or between electronic components of a given electronic equipment. The space is used for placing heat sinks and for allowing sufficient airflow. However, such forced air-cooling methods are generally not very efficient.

Liquid cooling technologies are increasingly used as a more efficient and cost-effective solution to maintain reliable operating temperatures of electronic equipment, such as servers, mounted in racks. Liquid cooling technologies include liquid immersion systems and water cooling channeling systems.

Liquid immersion systems typically comprise submerging the electronic equipment including the heat-generating electronic component(s) (e.g., server processor) in an immersion cooling liquid, which is a thermally conductive liquid that operates to remove heat from the heat-generating electronic component(s). Typically, the immersion cooling liquids comprise dielectric liquids containing hydrocarbons and/or fluorocarbons.

Water cooling channeling systems comprise water blocks that are mounted atop of the heat-generating electronic component(s). The water blocks incorporate an internal conduit that channels cooling water therethrough to operate as a water cooling heat sink. The water block is mounted on, and thermally coupled to, the heat-generating electronic component(s) (e.g., the processor of the server) via thermal interface materials (TIMs). TIMs manifest chemical properties that improve thermal conductivity and may take the form of inexpensive thermal pastes or expensive metal foils (*e.g.,* Indium foil).

With this water block configuration, cooling water flows through the internal conduit of the water block to collect thermal energy from the electronic component(s). The collected thermal energy is then directed elsewhere to be dissipated or expelled, such as, for example, by external dry cooling unit(s).

However, in some situations, liquid cooling solely based on either liquid immersion systems or water cooling channeling systems may not be sufficient to effectively dissipate the heat from the heat-generating electronic component(s).

It is, therefore, desirable to efficiently improve the cooling capacity and applications of liquid cooling technologies.

### SUMMARY

It is an object of the present technology to ameliorate at least some of the shortcomings present in the prior art.

Developers have observed that combining liquid immersion systems with water cooling channeling systems may improve the overall liquid cooling effect on heat generating electronic component(s). However, as noted above, liquid immersion systems employ dielectric liquids, such as hydrocarbons or fluorocarbons. These dielectric liquids manifest properties that are chemical incompatible with the thermal interface materials (TIMS) typically used with the water blocks, but are compatible with metal foils, such as, Indium foil.

However, Indium foils are significantly more expensive than the conventional thermal pastes. For example, an Indium foil for a water block for cooling a CPU costs about 100 times more than conventional thermal paste. This may be cost prohibitive when considering widespread implementation for hundreds of thousands heat-generating components. There are also, there are concerns as to the sustainability of Indium, as it is a mined metal and a finite resource.

Developers of the present technology have addressed these above-noted problems with a solution that provides a water block that can be used in immersion cooling, in which contact between the immersion cooling liquid and the TIM is prevented. Therefore, chemically incompatible combinations of the immersion cooling liquid and the TIM can be implemented without the fear of a chemical breakdown of either material, as contact between the two is eliminated. Equally notable, the use of expensive Indium foils can be avoided.

Broadly speaking, the water block of the present technology provides a liquid-proof sealing of a surface on which the thermal paste is applied when the water block is mounted to an electronic component submerged in immersion cooling liquid. Moreover, the presented water block arrangement is configured to protect electronic components having both common and atypical surface area dimensions. As such, the present technology provides cost effective and sustainable enhanced cooling of electronic components for a wide variety of combined water block and immersion liquid implementations.

According to one aspect of the present technology, there is provided a liquid cooling device mountable on an electronic component submerged in an immersion cooling liquid including a cooling device body having a first surface disposed on a bottommost side of the cooling device for mounting onto an upper surface of the electronic component, the first surface configured with a open recess formed along an outer periphery of the first surface, a thermal interface material (TIM) interposed between the first surface and the upper surface of the electronic component (50) to promote the thermal transfer therebetween, a second surface disposed on an uppermost side of the cooling device and in parallel and opposite positioning to the first surface, an internal fluid conduit configured to internally channel a circulating flow of a heat-transfer fluid therethrough, at least one side wall extending between the first surface and the second surface, and a resiliently deformable gasket mounted on, and seated within, the open recess along the outer periphery of the first surface to provide a seal that fluidly insulates the first surface (110) from the immersion cooling liquid. The gasket is configured to deformably expand horizontally and/ or vertically to establish a protective fluid-proof seal for the first surface of the cooling device body, the upper surface of the electronic component, and the TIM from the immersion cooling liquid.

In some embodiments, the liquid cooling device further comprises a second gasket mounted on a motherboard or socket and having an upper surface that interfaces with a bottom surface of the gasket to establish a protective fluid-proof seal from the immersion cooling liquid for a top surface of a motherboard or socket housing the electronic component and the first surface of the cooling device body, the upper surface of the electronic component, and the TIM.

In some other embodiments, the first and second gaskets have cross-sectional shapes comprising at least one of circular, oval, rectangular, and/or trapezoidal. Moreover, the first and second gaskets comprise a deformable elastomeric material that is resistant to immersion cooling liquid properties.

In additional embodiments, the deformable elastomeric material of the first and gaskets is configured to wedge into gaps between the cooling device body and the upper surface of the electronic component.

Embodiments of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Within the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Furthermore, the use of the phrase "at least one of A and B" is intended to mean A only, B only, or both A and B.

Moreover, unless expressly provided otherwise, the words "first", "second", "third", etc. have been used as adjectives only for the purpose of allowing for distinction between the nouns that they modify from one another, and not for the purpose of describing any particular relationship between those nouns. It should also be understood that terms relating to the position and/or orientation of components such as "upper", "lower", "top", "bottom", "front", "rear", "left", "right", are used herein to simplify the description and are not intended to be limitative of the particular position/orientation of the components in use.

Additional and/or alternative features, aspects and advantages of embodiments of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 is a perspective view of a water block configuration, in accordance with embodiments of the present technology;
FIG. 2A is a bottom view and FIG. 2B is a side view of the water block configuration of FIG. 1 without a gasket, in accordance with embodiments of the present technology;
FIG. 3A is a bottom view and FIG. 3B is a side view of the water block configuration of FIG. 1 with a gasket, in accordance with embodiments of the present technology;
FIG. 4 is a cross-sectional view of a first mounting arrangement for connecting a water block to an electronic component installed in a motherboard, in accordance with embodiments of the present technology; and
FIG. 5 is a cross-sectional view of a second mounting arrangement for connecting a water block to an electronic component installed in a motherboard, in accordance with embodiments of the present technology; and
FIG. 6 is a cross-sectional view of a third mounting arrangement for connecting a water block to an electronic component installed in a motherboard, in accordance with embodiments of the present technology.

It is to be understood that, unless otherwise explicitly specified herein, the drawings are not necessarily rendered to scale. Moreover, the drawings may exaggerate or omit features in order to assist in the clear understanding of the disclosed embodiments.

### DETAILED DESCRIPTION

The present technology will be described herein with respect to the configuration of a water cooling device that internally channels cooling water and is mounted atop of a heat-generating electronic component of a motherboard submerged in dielectric immersion cooling liquid.

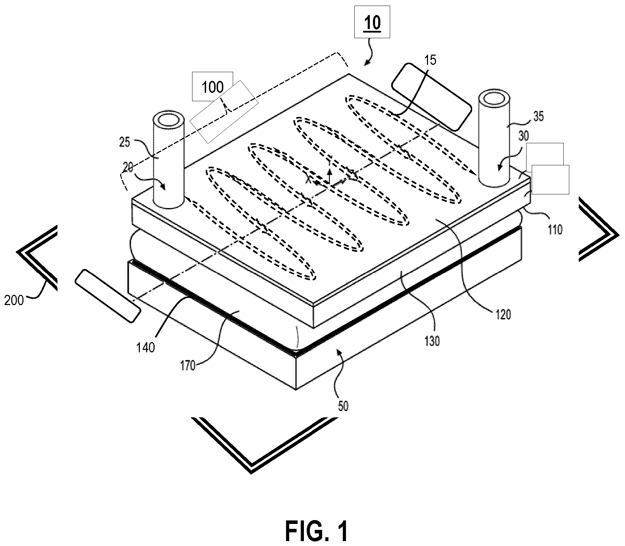

FIG. 1 depicts a perspective view of a water block **10** configuration, according to an embodiment of the present technology, in accordance with the embodiments of the present technology. As shown, the water block **10** comprises a body **100,** a first (*i.e.,* "lower") surface **110,** and a second (*i.e.,* "upper") surface **120.** The lower surface **110** is parallelly arranged opposite to the second water block surface **120.**

The water block body **100,** lower surface **110,** and second upper surface **120** are shown to manifest a generally square/rectangular shape defining four sidewalls **130** that extend vertically between the lower and upper surfaces **110, 120.** It will be appreciated, however, that the depicted shapes of the water block body **100,** lower and upper surfaces **110, 120** and sidewalls **130** are not intended to be limiting, as other shapes would be equally effective in view of the features of the present technology. For example, any one of the body **100** and lower and upper surfaces **110, 120** may comprise a circular, oval, or trapezoidal shape.

As noted above, water block **10** is configured to cool a heat-generating electronic component **50.** The heat-generating electronic component **50** may comprise a central processing unit (CPU), a graphics processing unit (GPU), a microcontroller unit (MCU) or any heat-generating electronic component. In use, the heat-generating electronic component **50** is mounted to a motherboard **200** (*e.g.*, printed circuit board (PCB)) or motherboard component socket. As will be described in further detail below, the water block **10,** heat-generating electronic component **50,** and motherboard/socket **200** are designed to be submerged in an immersion cooling liquid.

It will be appreciated that heat-generating electronic components **50** (*e.g.,* CPUs, GPUs, MCUs, *etc*.) come in a variety of different sizes and/or shapes. In turn, the structural configurations of water block bodies **100** are designed to generally comport with the most common contact surface area dimensions used by heat-generating electronic components **50.** However, to manufacture individual water block body **100** configurations that match atypical contact surface area dimensions would be cost-prohibitive and impractical. Therefore, as will be described in greater detail below, aspects of the present technology operate to mitigate this issue.

Returning to FIG. 1, water block **10** is arranged to be mounted atop of the heat-generating electronic component **50** for thermal contact via a thermal paste **140** therewith and to enable the water block **10** to absorb the heat generated by component **50.** To this end, water block body 100 comprises an internal fluid conduit **15** for channeling and circulating cooling water therethrough. In turn, the upper surface **120** of water block **10** incorporates a fluid inlet **20** connected to an inlet pipe **25** that is in fluid communication with the internal fluid conduit **15** for receiving and forwarding the cooling water to the internal fluid conduit **15.** Commensurately, the upper surface **120** also incorporates a fluid outlet **30** connected to an outlet pipe **35** that is in fluid communication with the internal fluid conduit **15** for receiving and discharging the water heated by the electronic component **50** from the internal fluid conduit **15.**

In the illustrated embodiment, internal fluid conduit **15** is shown to manifest a serpentine configuration. However, it should be appreciated that the depicted shape of internal fluid conduit **15** is not intended to be limiting, as other configurations of the internal fluid conduit 15 have been contemplated that are equally effective based on the present technology.

As noted above, water block **10** is mounted atop of the heat-generating electronic component **50** for direct thermal transfer contact, via a thermal paste **140,** in order for the internally circulating cooling water to absorb the heat generated by electronic component **50.** The thermal paste **140** may be applied to the lower water block surface **110** in a manner that is known in the art, to ensure adequate heat transfer between an upper contact surface of the electronic component **50** and the lower surface **110.**

The thermal paste **140** may comprise any suitable thermal paste which has adhesive and heat conducting properties. For example, thermal paste **140** may have a composition consisting of a bonding agent component and a particulate component. The particulate component may comprise particles of metal, minerals, and/or ceramics.

An aspect of the present technology addresses the issue that, while thermal pastes **140** are chemically incompatible with dielectric-based immersion cooling liquids containing hydrocarbons and/or fluorocarbons, the disclosed water block **10** configuration operates to sealably insulate any suitable thermal paste **140** from exposure to such immersion cooling liquids. Therefore, the need or use of cost-prohibitive TIMs that are chemically compatible to immersion cooling liquids, such as Indium foil, can be avoided for water blocks **10** submerged in dielectric-based immersion cooling liquids.

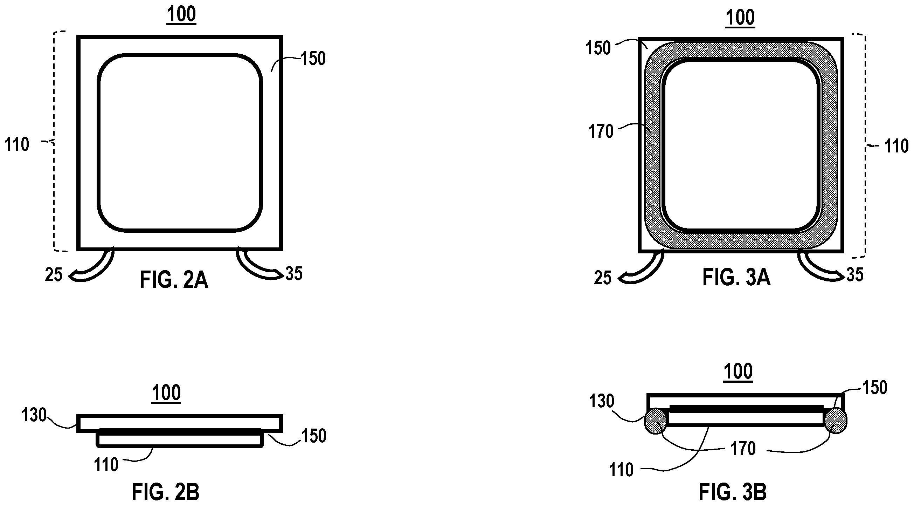

Turning back to FIG. 1, the water block **10** configuration depicts the use of a gasket **170.** To this end, as best seen in FIGs. 2A, 2B, the lower surface **110** of water block body **100** is configured with a continuous, peripherally-surrounding open recess **150** that is sized and shaped to accommodate the seating and housing of gasket **170.** The open recess **150** may be constructed or formed by any suitable manner. For example, recess **150** may be formed by milling by a numerically controlled milling machine, by molding equipment, or machining using electro-erosion techniques, *etc.*

The gasket **170** may be configured with any suitable cross-sectional profile. As shown in FIGs. 3A, 3B, gasket **170** is depicted as having a circular cross-sectional profile. However, in other embodiments, the cross-sectional profile of gasket **170** may comprise other shapes, such as, rectangular, oval, trapezoidal, *etc.*

The gasket **170** is comprised of a one piece construction and is sized and shaped to be fittingly seated and housed within the open recess **150.** The gasket **170** is made of a material that is compatible with dielectric-based immersion cooling liquid as well as being resiliently deformable to enable dimensional expansion when compressed during installation. As such, gasket **170** may be made of an elastomeric material, such as chloroprene, fluorosilicone rubber, polytetrafluoroethylene (PTFE), fluoroelastomer, butadiene acylonitrile, or nitriles.

In other embodiments, gasket **170** may comprise an epoxy resin, which may be applied to recess **150** prior to polymerization as a liquid or a gel and allowed to polymerize *in situ.* The epoxy resin precursor may be applied to recess **150** after the water block **10** has been mounted on electronic component **50,** so that it properly seals around the recess **150** and electronic component **50** when polymerized.

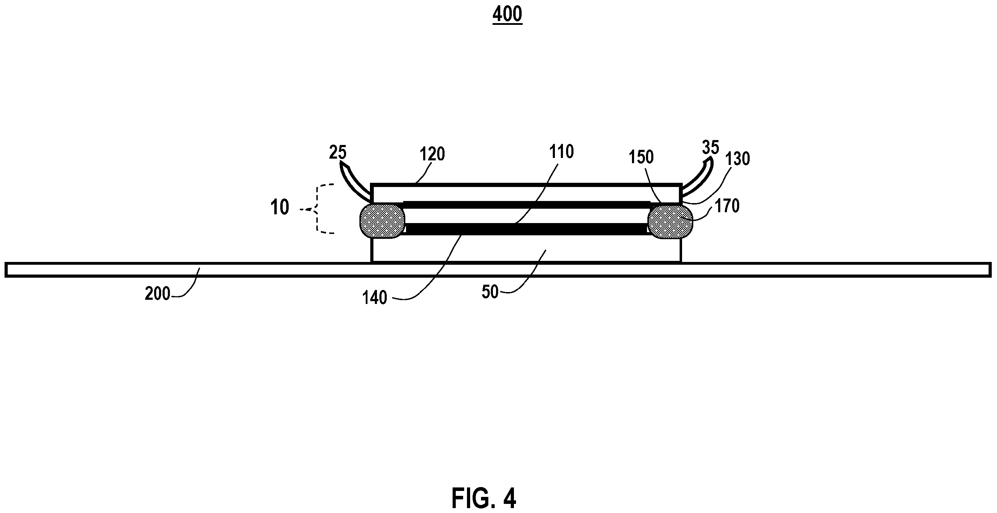

In view of the disclosures above, FIGs. 4, 5, 6 depict cross-sectional views of mounting arrangements **400, 500, 600** for the mounting of water block **10** onto electronic component **50** installed on motherboard/socket **200,** in accordance with the embodiments of the present technology. It will be appreciated that attributes of the depicted features may be exaggerated for clarity and ease of understanding.

As noted above, water block body **100** configurations are generally designed to comport with the most common contact surface area dimensions of heat-generating electronic components **50.** Accordingly, the depicted first mounting arrangement **400** of FIG. 4 is directed to the mounting of water block **10** that provides a fluid-proof seal to protect thermal paste **140** from immersion cooling liquid exposure for heat-generating electronic component **50** having common or typical contact surface area dimensions.

As shown, the mounting arrangement **400** provides for water block **10** to be mounted to electronic component **50,** via thermal paste **140,** such that the lower surface **110** of water block **10** and the applied thermal paste **140** are in direct thermal contact with the upper contact surface of electronic component **50.**

The gasket **170** is seated within recess **150** of the lower surface **110** of water block **10** and, due to compression forces upon mounting water block **10** to electronic component **50,** gasket **170** is configured to deform such that it outwardly expands ("bulges out"), along the horizontal direction, beyond the sidewall **130** edges and side edges of electronic component **50.**

The outward horizontal expansion of gasket **170** enables the first mounting arrangement to establish a fluid-proof seal between the lower surface **110** of water block **10,** the thermal paste **140,** and the upper surface of electronic component **50,** such that the thermal paste **140** is insulated and protected from any exposure to immersion cooling liquid.

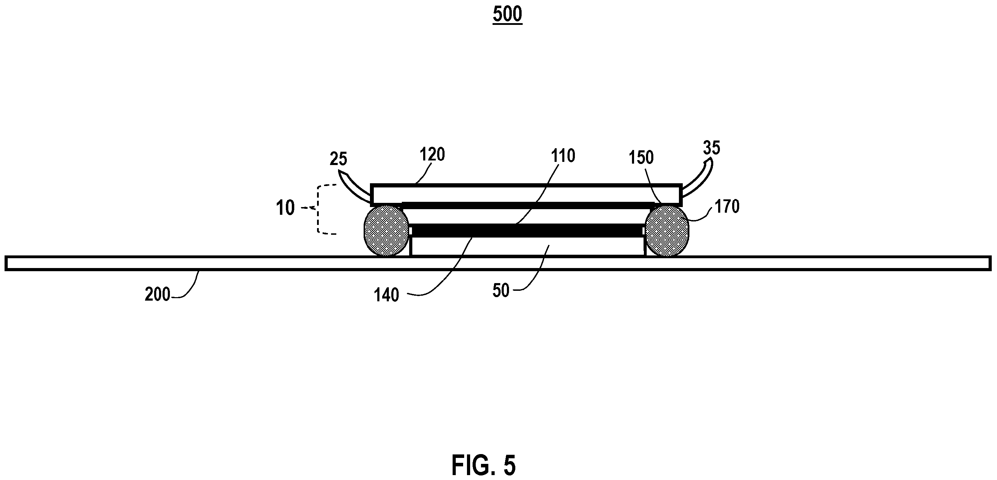

FIG. 5 depicts a cross-sectional view of a second mounting arrangement **500** for mounting water block **10** to electronic component **50** installed on motherboard/socket **200,** in accordance with the embodiments of the present technology.

As noted above, water block body **100** configurations are generally designed to comport with the most common or typical contact surface area dimensions of heat-generating electronic components **50.** However, it is neither cost effective nor practical to design different water block body **100** configurations to perfectly match typical contact surface area dimensions implemented by some heat-generating electronic components **50.** Accordingly, the mounting arrangement **500** is directed to the mounting of water block **10** that provides a fluid-proof seal to protect thermal paste **140** from immersion cooling liquid for heat-generating electronic component **50** having an atypical shape (*e.g.,* a trapezoidal shape).

The mounting arrangement **500** shares many of the aspects provided by the first mounting arrangement. Namely, the second mounting arrangement includes the mounting of the water block **10** onto the electronic component **50,** via thermal paste **140,** such that the lower surface **110** of water block **10** and the applied thermal paste **140** are in direct thermal contact with the upper contact surface of electronic component **50.** Also, the gasket **170** is seated within recess **150** of the lower surface **110** of water block **10** and, due to compression forces upon mounting water block **10** to electronic component **50,** gasket **170** is deformed to outwardly expand ("bulges out"), along the horizontal direction, beyond the sidewall **130** edges and side edges of electronic component **50.**

However, unlike the first mounting arrangement **400,** the second mounting arrangement **500** provides a fluid-proof seal to protect thermal paste **140** from immersion cooling liquid for heat-generating electronic components **50** having atypical contact surface area dimensions. That is, as indicated by FIG. 5, for the mounting arrangement **500,** the gasket **170** is additionally configured to deform and expand along the vertical direction ("bulges down") due to compression forces upon installation, to make a sealable contact with the surface of motherboard/socket **200.**

As such, the second mounting arrangement provides the fluid-proof sealing of the water block lower surface **110,** the thermal paste **140,** and the upper surface of electronic component **50** along the horizontal and vertical directions for atypical electronic component **50** surface area dimensions.

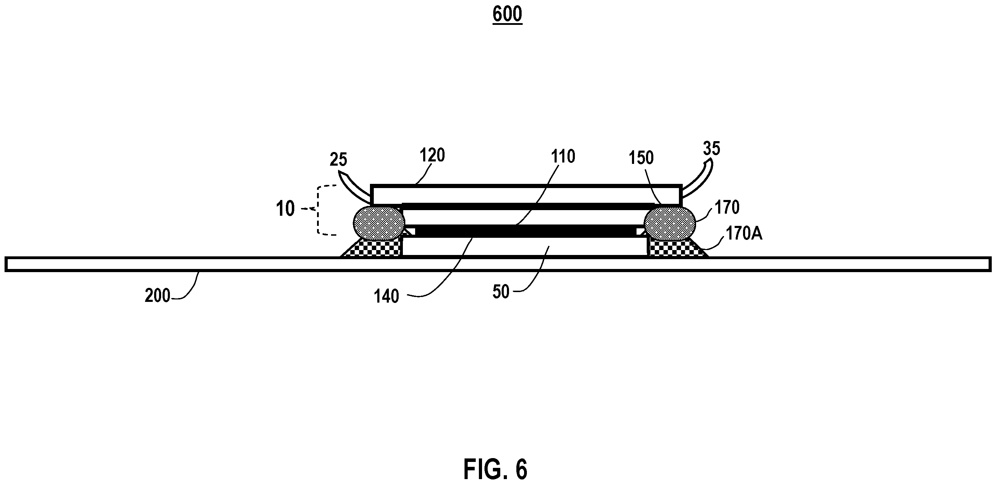

FIG. 6 depicts a cross-sectional view of a third mounting arrangement **600** for mounting water block **10** to electronic component **50** installed on motherboard/socket **200,** in accordance with the embodiments of the present technology.

Like mounting arrangement **500,** mounting arrangement **600** is directed to atypical contact surface area dimensions. However, mounting arrangement **600** incorporates a dual gasket **170, 170A** implementation. That is, like mounting arrangement **400,** mounting arrangement **600** employs a first gasket **170A** having a circular cross-section that outwardly expands ("bulges out"), along the horizontal direction, due to mounting compression forces.

In addition, mounting arrangement **600** employs a second gasket **170A** having a trapezoidal cross-section that is mounted on the motherboard/socket **200** having a top surface that interfaces with a bottom surface of first gasket **170.** When two rubber gaskets **170, 170A** are compressed, they fill any gaps or crevices between the surfaces, including for example, wedging into spaces between the water block lower surface **110** and the upper surface of electronic component **50,** to block any leaks.

Because the elastomeric material is flexible, it adapts to uneven surfaces and stays effectively sealed even with movement or temperature changes. So, the idea of using two gaskets instead of one is to securely attach components with different geometries (water block and processor), with each gasket sealing against one component. This ensures a perfect fit and reliable sealing for both parts. Mounting arrangement **600,** therefore, provides the fluid-proof sealing of the water block lower surface **110,** the thermal paste **140,** and the upper surface of electronic component **50** along the horizontal and vertical directions.

It will be appreciated that the capability of the disclosed water block **10** configuration to provide fluid-proof insulative sealing protection from the immersion cooling liquid properties for both, common and atypical surface area dimensions of electronic components **50** yields numerous technical and manufacturing advantages. For example, the disclosed water block **10** configuration achieves insulative protection for the water block lower surface **110,** the thermal paste **140,** and the upper surface of electronic component **50** for common and atypically-dimensioned electronic components **50** without the need for fabricating tailored water blocks for atypically-dimensioned electronic components **50.**

Moreover, the disclosed water block **10** configuration mitigates the need for incorporating cost-prohibitive TIM materials, such as Indium, to provide protection against the immersion liquid properties.

In this manner, the disclosed embodiments of the present technology provide a liquid cooling device arrangement incorporating an open recess and a seated resiliently deformable gasket configured to horizontally or vertically expand to establish a fluid-proof seal that protects the TIM from immersion cooling liquids. As such, the present technology is capable or rendering cost effective and sustainable protection for a wide variety of combined water block and immersion liquid implementations.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A liquid cooling device (10) mountable on an electronic component (50) submerged in an immersion cooling liquid, the cooling device (10) comprising:
a cooling device body (100) comprising:
a first surface (110) disposed on a bottommost side of the cooling device (10) for mounting onto an upper surface of the electronic component (50), the first surface (110) configured with a open recess (150) formed along an outer periphery of the first surface (110);
a thermal interface material (TIM) (140) interposed between the first surface (110) and the upper surface of the electronic component (50) to promote the thermal transfer therebetween;
a second surface (120) disposed on an uppermost side of the cooling device (10) and in parallel and opposite positioning to the first surface (110);
an internal fluid conduit (15) configured to internally channel a circulating flow of a heat-transfer fluid therethrough;
at least one side wall (130) extending between the first surface (110) and the second surface (120); and
a resiliently deformable gasket (170) mounted on, and seated within, the open recess (150) along the outer periphery of the first surface (110) to provide a seal that fluidly insulates the first surface (110) from the immersion cooling liquid,
wherein the gasket (170) is configured to deformably expand horizontally beyond the sidewall (130) edges and side edges of electronic component (50) to establish a protective fluid-proof seal for the first surface (110) of the cooling device body (100), the upper surface of the electronic component (50), and the TIM (140) from exposure to the immersion cooling liquid.

2. The liquid cooling device (10) of claim 1, wherein the gasket (170) is further configured to deformably expand vertically to establish a protective fluid-proof seal from the immersion cooling liquid for a top surface of a motherboard or socket (200) housing the electronic component (50) and the first surface (110) of the cooling device body (100), the upper surface of the electronic component (50), and the TIM (140).

3. The liquid cooling device (10) of claim 1 further comprising a second gasket (170A) mounted on a motherboard or socket (200) and having an upper surface that interfaces with a bottom surface of the gasket (170) to establish a protective fluid-proof seal from the immersion cooling liquid for a top surface of a motherboard or socket (200) housing the electronic component (50) and the first surface (110) of the cooling device body (100), the upper surface of the electronic component (50), and the TIM (140).

4. The liquid cooling device (10) of claims 1 or 3, wherein the first and second gaskets (170, 170A) have cross-sectional shapes comprising at least one of circular, oval, rectangular, and/or trapezoidal.

5. The liquid cooling device (10) of claim 4, wherein the first and second gaskets (170, 170A) comprise a deformable elastomeric material that is resistant to, and/or compatible with, the immersion cooling liquid properties.

6. The liquid cooling device (10) of claim 5 wherein, upon compression, the deformable elastomeric material of the first and second gaskets (170, 170A) is configured to wedge into gaps between the cooling device body (100) and the upper surface of the electronic component (50).

7. The liquid cooling device (10) of claims 5 or 6, wherein the first and second gaskets (170, 170A) deformable elastomeric material comprises at least one of: chloroprene, fluorosilicone rubber, polytetrafluoroethylene (PTFE), fluoroelastomer, butadiene acylonitrile, and/or nitriles.

8. The liquid cooling device (10) of anyone of claims 3 to 7, wherein the first and second gaskets (170, 170A) are comprised of a one-piece construction.

9. The liquid cooling device (10) of any of claims 3 to 9, wherein the open recess (150) of the first surface (110) configured receive the first and second gaskets (170, 170A) for mounting contain a general outline shape comprising one of a: square, rectangle, circle, oval, or trapezoid.

10. The liquid cooling device (10) of claim 8, wherein the first and second gaskets (170, 170A) contain a general outline shape for mounting onto the open recess (150) that comprises one of a: square, rectangle, circle, oval, or trapezoid.

11. The liquid cooling device (10) of any of claims 1 to 10, wherein the TIM (140) comprises a thermal paste having a composition that incorporates a bonding component and a particulate component, wherein the particulate component comprises at least one of: metal particles, minerals, and/or ceramics.

12. The liquid cooling device (10) of claim 11, wherein the TIM (140) composition does not include Indium.

13. The liquid cooling device (10) of any of claims 1 to 12, wherein the body (100) further comprises a cold inlet (25) to facilitate ingress flow of the heat-transfer fluid to the internal fluid conduit (15) and a hot outlet (35) to facilitate egress flow of the heat-transfer fluid from the internal fluid conduit (15).

14. The liquid cooling device (10) of claim 13, wherein the internal fluid conduit (15) comprises a serpentine-shaped configuration that is fluidly-coupled to the cold inlet (25) and the hot outlet (35).

15. The liquid cooling device (10) of any of claims 1 to 14, wherein the heat-transfer fluid comprises water.

16. The liquid cooling device (10) of any of claims 1 to 15, wherein the dielectric-based immersion cooling liquid contains hydrocarbons and/or fluorocarbons.

## Amended claims

### Amended claims in accordance with Rule 137(2) EPC.

1. A liquid cooling device (10) mountable on an electronic component (50) submerged in an immersion cooling liquid, the cooling device (10) comprising:
a cooling device body (100) comprising:
a first surface (110) disposed on a bottommost side of the cooling device (10) for mounting onto an upper surface of the electronic component (50), the first surface (110) configured with a open recess (150) formed along an outer periphery of the first surface (110);
a thermal interface material (TIM) (140) interposed between the first surface (110) and the upper surface of the electronic component (50) to promote the thermal transfer therebetween;
a second surface (120) disposed on an uppermost side of the cooling device (10) and in parallel and opposite positioning to the first surface (110);
an internal fluid conduit (15) configured to internally channel a circulating flow of a heat-transfer fluid therethrough;
at least one side wall (130) extending between the first surface (110) and the second surface (120); and
a first gasket (170) mounted on, and seated within, the open recess (150) along the outer periphery of the first surface (110) to provide a seal that fluidly insulates the first surface (110) from the immersion cooling liquid, the first gasket (170) is being configured to deformably expand horizontally beyond the sidewall (130) edges and side edges of electronic component (50) to establish a protective fluid-proof seal for the first surface (110) of the cooling device body (100), the upper surface of the electronic component (50), and the TIM (140) from exposure to the immersion cooling liquid;
the liquid cooling device (10) **characterized by**:
a second gasket (170A) mounted on a motherboard or socket (200) and having an upper surface that interfaces with a bottom surface of the gasket (170) to establish a protective fluid-proof seal from the immersion cooling liquid for a top surface of a motherboard or socket (200) housing the electronic component (50) and the first surface (110) of the cooling device body (100), the upper surface of the electronic component (50), and the TIM (140);
the first and second gaskets (170, 170A) comprise a deformable elastomeric material that is resistant to, and/or compatible with, the immersion cooling liquid properties,
wherein, upon compression, the deformable elastomeric material of the first and second gaskets (170, 170A) is configured to wedge into gaps between the cooling device body (100) and the upper surface of the electronic component (50).

2. The liquid cooling device (10) of claim 1, wherein the first gasket (170) is further configured to deformably expand vertically to establish a protective fluid-proof seal from the immersion cooling liquid for a top surface of a motherboard or socket (200) housing the electronic component (50) and the first surface (110) of the cooling device body (100), the upper surface of the electronic component (50), and the TIM (140).

3. The liquid cooling device (10) of claims 1 or 2, wherein the first and second gaskets (170, 170A) have cross-sectional shapes comprising at least one of circular, oval, rectangular, and/or trapezoidal.

4. The liquid cooling device (10) of claims 1 to 3, wherein the deformable elastomeric material of the first and second gaskets (170, 170A) comprises a material that is resistant to, and/or compatible with, the immersion cooling liquid properties.

5. The liquid cooling device (10) of claims 1 to 4, wherein the first and second gaskets (170, 170A) deformable elastomeric material comprises at least one of: chloroprene, fluorosilicone rubber, polytetrafluoroethylene (PTFE), fluoroelastomer, butadiene acylonitrile, and/or nitriles.

6. The liquid cooling device (10) of anyone of claims 1 to 5, wherein the first and second gaskets (170, 170A) are comprised of a one-piece construction.

7. The liquid cooling device (10) of any of claims 1 to 6, wherein the open recess (150) of the first surface (110) configured receive the first and second gaskets (170, 170A) for mounting contain a general outline shape comprising one of a: square, rectangle, circle, oval, or trapezoid.

8. The liquid cooling device (10) of claim 6, wherein the first and second gaskets (170, 170A) contain a general outline shape for mounting onto the open recess (150) that comprises one of a: square, rectangle, circle, oval, or trapezoid.

9. The liquid cooling device (10) of any of claims 1 to 8, wherein the TIM (140) comprises a thermal paste having a composition that incorporates a bonding component and a particulate component, wherein the particulate component comprises at least one of: metal particles, minerals, and/or ceramics.

10. The liquid cooling device (10) of claim 9, wherein the TIM (140) composition does not include Indium.

11. The liquid cooling device (10) of any of claims 1 to 10, wherein the body (100) further comprises a cold inlet (25) to facilitate ingress flow of the heat-transfer fluid to the internal fluid conduit (15) and a hot outlet (35) to facilitate egress flow of the heat-transfer fluid from the internal fluid conduit (15).

12. The liquid cooling device (10) of claim 11, wherein the internal fluid conduit (15) comprises a serpentine-shaped configuration that is fluidly-coupled to the cold inlet (25) and the hot outlet (35).

13. The liquid cooling device (10) of any of claims 1 to 12, wherein the heat-transfer fluid comprises water.

14. The liquid cooling device (10) of any of claims 1 to 13, wherein the dielectric-based immersion cooling liquid contains hydrocarbons and/or fluorocarbons.
